# FASCICULE DE BREVET EUROPEEN

(11) **EP 2 171 752 B1**
(45) Date de publication et mention de la délivrance du brevet: **04.06.2014**
(21) Numéro de dépôt: 08826843.8
(22) Date de dépôt: 17.07.2008
(51) Int. Cl.: H01L 21/56

(54) **PROCÉDÉ D'ENROBAGE DE DEUX ÉLÉMENTS HYBRIDES ENTRE EUX AU MOYEN D'UN MATÉRIAU DE BRASURE**
VERFAHREN ZUR BESCHICHTUNG ZWEIER MITTELS EINES LÖTMATERIALS HYBRIDISIERTER ELEMENTE
METHOD FOR COATING TWO ELEMENTS HYBRIDIZED BY MEANS OF A SOLDERING MATERIAL

(30) Priorité: 23.07.2007 FR 0705330
(43) Date de publication de la demande: 07.04.2010
(73) Titulaire: Commissariat à l'Énergie Atomique et aux Énergies Alternatives, 75015 Paris (FR)
(72) Inventeur: KOPP, Christophe, F-38120 Fontanil-Cornillon (FR); BABLET, Jacqueline, F-38450 Le Gua (FR); RABY, Jacques, F-38000 Grenoble (FR); ROSSAT, Cyrille, F-38590 Saint Etienne De Saint Geoirs (FR)
(74) Mandataire: Vuillermoz, Bruno
(86) Numéro de dépôt international: PCT/FR2008/051352
(87) Numéro de publication internationale: WO 2009/016304

(56) Documents cités:
- FR-A- 2 704 691
- US-A1- 2004 005 732
- US-A1- 2004 121 512
- US-A1- 2007 099 346

## Description

### DOMAINE DE L'INVENTION

La présente invention concerne le domaine de la microélectronique, et plus particulièrement celui des techniques d'hybridation par billes de deux composants hétérogènes, également appelées billes de brasures. Elle se rattache donc au domaine général des microcomposants, plus classiquement dénommés puces électroniques, mais également susceptible de s'appliquer aux micro capteurs, micro actuateurs, tels que les MEMS (selon l'expression anglo-saxonne « *Micro Electro Mecanicals Systems* »), également aux composants optoélectroniques, du type VCSEL (pour l'expression anglo-saxonne « *Vertical Cavities Semi Conductor Emitting Laser* ») etc...

Au sens de l'invention, on entend par composant, un capteur électronique, tel qu'une puce électronique, un support de circuit électrique ou électronique, ou encore un composant électrique passif du type capot de protection, voire même un capteur de grandeur physique.

### ETAT ANTERIEUR DE LA TECHNIQUE

Les microcomposants dont il est question dans le cadre de la présente invention sont classiquement déposés sur un substrat de nature appropriée, par exemple de type semiconducteur (silicium monocristallin, saphir, etc...) pour des composants électroniques.

Un tel substrat est muni de pistes conductrices de l'électricité, par exemple réalisées en aluminium, qui rayonnent à partir du microcomposant en direction de la périphérie du substrat, afin de permettre, outre l'alimentation électrique du composant, le cas échéant requise, également et surtout le traitement de l'exploitation des signaux que ledit composant est appelé à générer, voire le pilotage des fonctions qu'il incorpore.

Pour assembler différents composants entre eux, l'une des techniques aujourd'hui largement répandue est celle de l'hybridation par billes dite « *flip chip* ». Cette technologie consiste succinctement :
- à déposer sur une ou plusieurs surfaces mouillables, mises en places sur l'un des composants à assembler, le matériau constitutif des billes de soudure selon une quantité appropriée ;
- à munir l'autre composant à hybrider de surfaces mouillables par ledit matériau de soudure, lesdites surfaces étant ménagées sensiblement à l'aplomb des surfaces dudit premier composant lorsque le second composant est reporté sur le premier ;
- à déposer un flux de matériau se présentant sous forme liquide, ledit flux remplissant une fonction chimique de désoxydation et d'empêchement de la ré-oxydation pendant la brasure, une fonction thermique permettant d'assurer le transfert de chaleur, et une fonction physique permettant de diminuer les tensions de surface et dès lors de favoriser la formation des billes proprement dites ;
- puis, à mettre en contact la surface de mouillabilité de l'autre composant avec le matériau de brasure ainsi déposé ;
- et enfin, à élever la température jusqu'à atteindre une température supérieure à la température de fusion du matériau constitutif des billes pour obtenir la fusion de celles-ci jusqu'à aboutir au résultat recherché, à savoir l'hybridation du premier composant sur le second composant, lesdites billes créant un lien mécanique et/ou électrique entre les surfaces mouillables de chacun des composants, l'une au moins desdites surfaces mouillables étant elles-mêmes reliées aux pistes conductrices ménagées sur ce dernier.

Ainsi, au cours du procédé d'assemblage, le matériau de brasure constitutif des billes adopte-il la forme d'une bille.

En raison du grand nombre de composants susceptibles d'être hybridés sur une même surface de substrat, une attention particulière au problème de la tenue mécanique des circuits ainsi réalisés doit être mise en oeuvre. Afin d'optimiser cette tenue mécanique, il est connu d'enrober les composants électroniques ainsi obtenus après hybridation.

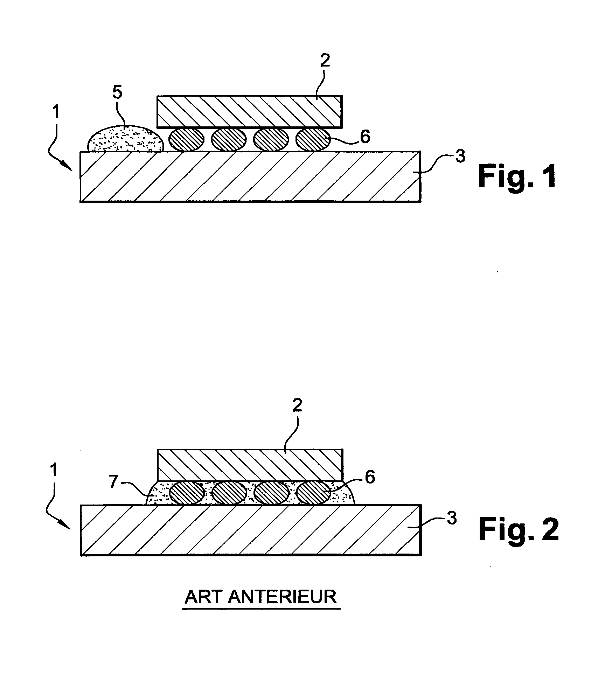

On a de fait représenté en relation avec les figures 1 et 2 une technique d'enrobage de l'état antérieur de la technique.

Ce procédé d'enrobage peut consister à déposer une goutte calibrée 5 de substance d'enrobage, telle qu'une résine d'enrobage, sur le substrat 3 ou circuit de lecture d'un composant 1, à proximité de l'hybridation d'une puce 2 sur ledit substrat.

Cette goutte calibrée 5 de résine est déposée près du composant électronique hybridé par billes, ladite goutte de résine migrant par capillarité sous le composant électronique ou puce 2 rapporté par hybridation. En d'autres termes, la résine va occuper le volume défini entre le composant électronique et le substrat et venir entourer les billes d'hybridation 6. On définit ainsi l'enrobage 7 garantissant la tenue mécanique dans le temps du composant ainsi obtenu après hybridation.

Cette technique d'enrobage se heurte cependant à un certain nombre de difficultés.

En premier lieu, afin d'assurer la mise en oeuvre du phénomène de capillarité, assurant la migration effective de la résine d'enrobage, la goutte de résine doit être déposée suffisamment près du composant à hybrider pour engendrer un phénomène de tension superficielle sous-tendant la capillarité.

Parallèlement, le volume de résine doit être suffisamment important pour permettre de combler entièrement l'espace défini entre le composant 2 et le substrat 3. Cependant, cette quantité ne doit pas être non plus trop excessive pour éviter que ladite résine ne s'étale au-delà du substrat, susceptible dans une telle hypothèse d'empêcher l'hybridation d'autres composants à proximité.

Un perfectionnement à cette technique d'enrobage a été décrit, par exemple dans le document FR 2 704 691. Succinctement, celui-ci consiste à positionner un tapis de billes à proximité des billes destinées à hybrider le composant sur le substrat, ladite résine d'enrobage étant déposée sur ce tapis de billes. Ce dernier assure la migration de la résine par capillarité en direction du composant hybridé, permettant ainsi de résoudre de manière simple le problème inhérent à la proximité.

Cependant, ce perfectionnement ne résout pas le problème de la maîtrise de l'étalement de la résine d'enrobage au-delà du composant hybridé, et un surplus de résine est toujours susceptible de s'étaler sur le substrat. Afin de s'affranchir de cette difficulté, on a proposé également la réalisation d'un cordon de colle périphérique par rapport au composant, ledit cordon faisant fonction de barrage, la résine d'enrobage étant déposée à l'intérieur dudit cordon.

Cependant, cette technique se heurte également à divers inconvénients parmi lesquels on peut citer le fait que le procédé mis en oeuvre s'effectue en deux étapes, pénalisant la durée de fabrication.

De plus, la mise en oeuvre d'un tel cordon s'avère consommateur de surface sur le substrat, réduisant de fait la capacité de rapprochement et de concentration des composants sur un même substrat.

Le document US 2007/99346 décrit un procédé d'enrobage de la zone d'hybridation d'un composant, dans lequel on définit à la périphérie de ladite zone une surface non mouillante vis-à-vis de la matière d'enrobage.

Le document US 2004/121512 décrit un procédé d'enrobage d'un composant, dans lequel l'un des éléments dudit composant subit un traitement plasma afin de définir une zone non mouillante.

L'invention se propose précisément de solutionner ces différents problèmes.

### EXPOSE DE L'INVENTION

Elle vise ainsi, dans un premier temps, un procédé d'enrobage de la zone d'hybridation d'un composant constitué de deux éléments associés l'un à l'autre au moyen d'un matériau de brasure.

Ce procédé consiste à déposer à proximité dudit composant une substance d'enrobage, également dénommée résine d'underfill dans le domaine technique considéré, susceptible de venir combler par capillarité le volume défini entre les éléments hybridés dudit composant. On définit à la périphérie de la zone d'hybridation sur l'élément inférieur dudit composant une zone de non mouillabilité vis-à-vis de la dite substance, par dépôt d'un revêtement anti-mouillant vis à vis de la dite substance.

Selon l'invention, ce dépôt étant réalisé par PECVD (pour l'expression anglo-saxonne *« Plasma Enhanced Chemical Vapor Deposition* »). En outre, ladite zone de non-mouillabilité comporte une extension, contiguë et en continuité avec elle, et destinée à recueillir la substance d'enrobage en excès.

Ce faisant, la zone de non mouillabilité fait barrage par rapport à la substance d'enrobage, évitant ainsi tout risque de dispersion de la substance d'enrobage sur ledit élément inférieur, et de manière générale sur le substrat sur lequel est hybridé ledit composant.

Selon l'invention, le revêtement anti-mouillant, de faible épaisseur, est par exemple constitué de SiOC ou de C₄F₈.

Selon une caractéristique avantageuse de l'invention, on définit une surface continue sur ledit premier élément ou sur le substrat, à l'aplomb de la zone d'hybridation dont on souhaite réaliser l'enrobage, et destinée à recevoir ladite substance d'enrobage.
Cette zone mouillante vis à vis de ladite substance d'enrobage est définie par défaut, en ce sens que l'on applique à sa périphérie un revêtement non-mouillant vis à vis de la substance d'enrobage.

Selon une caractéristique de l'invention, cette zone comprend une première extension, située de manière contiguë et en continuité avec ladite zone mouillante, et destinée à servir de surface de réception de la goutte de substance d'enrobage.

Avantageusement, la surface de recueil de la substance d'enrobage en excès est située de manière opposée à ladite extension de réception par rapport au composant hybridé dont on souhaite réaliser l'enrobage.
En d'autres termes, dans ces deux configurations, la zone de non mouillabilité, par définition périphérique au composant hybridé, présente une ou deux extensions pour définir respectivement une zone de réception de la substance d'enrobage et une zone de recueil de la dite substance d'enrobage en excès.

Selon une caractéristique particulière de l'invention, plus particulièrement destinée aux composants opto-électroniques, on définit également une surface de non mouillabilité par rapport à la substance d'enrobage sur ledit premier élément ou sur le substrat sur lequel vient s'hybrider le second élément, située au sein de la zone d'hybridation et au niveau d'une zone particulière dans laquelle on ne souhaite pas la présence de la substance d'enrobage.
Cette configuration peut se retrouver dans le cadre des composants opto-électroniques pour lesquels on peut souhaiter hybrider un laser, le substrat étant alors percé d'un orifice traversant, afin de laisser passer le faisceau laser et accueillir une fibre optique.

Selon un second objectif de l'invention, le procédé visé permet de conférer au revêtement anti-mouillant ainsi obtenu, à nouveau des propriétés de mouillabiltié. Cette inversion de caractéristique de mouillabilité est obtenue, conformément à l'invention, en soumettant le revêtement anti-mouillant à l'action d'un plasma ou à l'action d'un rayonnement ultra-violet. Ce faisant, après hybridation entre eux des éléments constitutifs du composant au moyen de la résine dite d'« underfill », conformément à ce qui précède, on enrobe l'ensemble d'une autre résine, qualifiée dans le domaine considéré de « glob-top », conférant audit composant une excellente cohésion mécanique.

Autrement dit, cette réversibilité des propriétés de mouillabilité permet d'enrober au moyen d'une résine d'enrobage ou « glob-top » avec une bonne adhérence des composants préalablement hybridés par « flip chip », et ont les contacts électriques sous la puce ou sous l'élément hybridé ont été enrobés par une résine d'underfill de façon contrôlée grâce à des barrières de dépôts hydrophobes, et donc, ne pouvant pas être collés de manière efficace. En effet, sur des dépôts laissés hydrophobes, un enrobage de type « glob-top » collerait mal, favorisant les amorces de rupture.

Il sera utilement rappelé que la mouillabilité diminue lorsque le caractère hydrophobe augmente.

### DESCRIPTION DES FIGURES

La manière dont l'invention peut être réalisée et les avantages qui en découlent, ressortiront mieux des exemples de réalisation qui suivent, donnés à titre indicatif et non limitatif, à l'appui des figures annexées.
Les figures 1 et 2 sont, comme déjà dit, des représentations schématiques du principe d'enrobage selon l'état antérieur de la technique.
La figure 3 est une vue de dessus du procédé d'enrobage d'un composant hybridé conforme à l'invention.
La figure 4 est une vue de dessus analogue à la figure 3 d'une variante.
La figure 5 illustre la mise en oeuvre d'un composant optoélectronique hybridé enrobé conformément au procédé de l'invention vue en section, la figure 6 étant une vue du dessus.
La figure 7 est une représentation schématique d'un composant hybridé conformément à l'invention, et mettant en oeuvre une barrette de laser et une barrette de lentille dans le cadre d'un composant optronique.
Les figures 8a, 8b et 8c visent à illustrer le caractère réversible des propriétés de mouillabilité du revêtement mis en place conformément à l'invention.

### DESCRIPTION DETAILLEE DES MODES DE REALISATION DE L'INVENTION

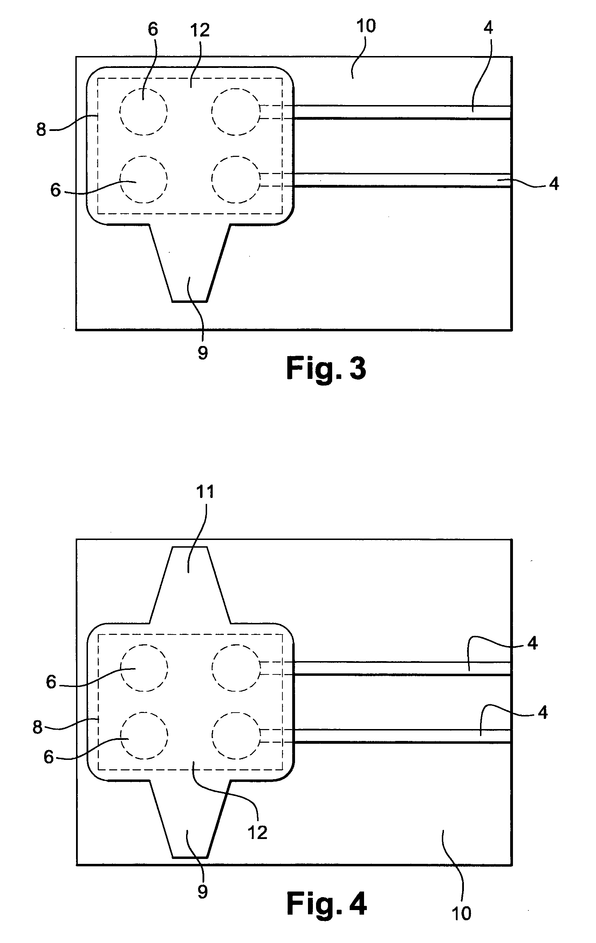

On a décrit, en relation avec les figures 3 et 4, un procédé d'enrobage d'un composant obtenu après hybridation. Celui-ci repose fondamentalement sur le principe de la migration d'une résine d'enrobage ou résine d'underfill 7 dans le volume ou l'espace défini par les composants hybridés 2 et 3, venant ainsi assurer la tenue mécanique du composant hybridé et la résistance notamment des microbilles 6 en suite des différentes sollicitations auxquelles peut être confrontées le capteur mettant en oeuvre un tel composant hybridé.

Cette résine d'enrobage peut être composée d'époxy, mais peut également être choisie dans le groupe comprenant les acrylates et les silicones.

Afin de confiner la résine d'enrobage dans l'espace inter-composant, on revêt le composant inférieur, en l'espèce le substrat 3, d'une fine couche de matériau de non mouillabilité vis-à-vis de ladite substance, à l'exception de la zone d'hybridation.

On a ainsi représenté en relation avec la figure 3 une vue du dessus de la seule partie inférieure du composant. La référence 8 illustre en traits discontinus le périmètre du composant, et la référence 12 la zone de confinement de la résine.

Selon l'invention, on définit également, toujours par la mise en oeuvre du revêtement à non-mouillabilité vis à vis de la résine d'enrobage, une zone de dépôt 9 de la quantité nécessaire en résine d'enrobage. En raison du confinement de ladite résine d'enrobage par la présence du revêtement de non mouillabilité pour toute la périphérie du composant, on s'assure de la non migration de ladite résine d'enrobage au-delà de la surface nécessaire, permettant ainsi de pallier les inconvénients de l'état antérieur de la technique.

En raison de ce confinement de la résine d'enrobage, il devient ainsi possible d'augmenter la concentration de composants hybridés sur un même substrat puisque l'on ne se heurte plus aux problèmes liés à la migration de ladite résine d'enrobage au-delà de la zone intercomposante.

Le revêtement à non-mouillabilité vis à vis de la résine d'enrobage est de faible épaisseur, typiquement comprise entre 10 et 500 nm, et est par exemple constitué de SiOC ou de C₄F₈.

Le dépôt de ce revêtement est réalisé par PECVD (pour l'expression anglo-saxone *« Plasma Enhanced Chemical Vapor Deposition* » à partir d'un précurseur, en l'espèce l'OMCTS pour « *Octamethylcyclotetrasiloxane » )* et en utilisant un gaz porteur tel que l'argon ou l'hydrogène.

Selon la puissance du plasma, la pression, la concentration initiale en précurseur et la durée du dépôt plasma, on peut contrôler l'épaisseur de la couche déposée et sa stoechiométrie SiOₓ₁C_{y1}H_{z1}. Le matériau SiOₓ₁C_{y1}H_{z1} est de formulation telle que 0,3 ≤ x1 ≤ 0,4 et 0,15≤y1 ≤ 0,2 et 0,4 ≤ z1 ≤ 0,55.

Bien évidemment, ce procédé de dépôt et les traitements correspondants peuvent être généralisés à d'autres types de siloxanes de formulation proche, tel que par exemple le TNCTS pour « *tétraéthylcyclotetrasiloxane* ».

Ce matériau peut en outre être traité et transformé en surface en un matériau de formulation générale SiOₓ₂C_{y2}Hₓ₂ , avec x₂>>x₁, y₂<<y₁ et z₂<<z₁, ou plus simplement SiOₓ, dans lequel x tend vers 2 pour notamment augmenter la valeur de son énergie de surface, en particulier polaire, et induire une très forte mouillabilité des liquides (de l'ordre de 5° d'angle de contact pour l'eau), et une très forte augmentation de l'adhérence et du développement cellulaire (passage d'un temps de génération de 40 heures sur OMCTS brut à 20 heures sur de l'OMCTS traité).

Les traitements utilisés sont soit de type plasma, à savoir un plasma d'hélium ou des plasmas d'oxygène 0₂, SF₆ + O₂, CHF₃ +O₂ ...), soit de type UV dans l'air ambiant ou dans une atmosphère enrichie en oxygène.

Ces traitements sur ce type de dépôt ont donc la particularité de rendre mouillable vis-à-vis d'une substance une zone initialement non mouillable vis-à-vis de ladite substance. En d'autres termes, la propriété initiale de faible mouillabilité ou de non-mouillabilité du dépôt devient réversible.

On peut ainsi avantageusement mettre en oeuvre cette caractéristique pour améliorer l'adhérence des résines de recouvrement, également dénommées « glop-top » dans le domaine technique considéré, destinées, de manière connue, à favoriser et optimiser la cohésion mécanique du composant obtenu après hybridation.

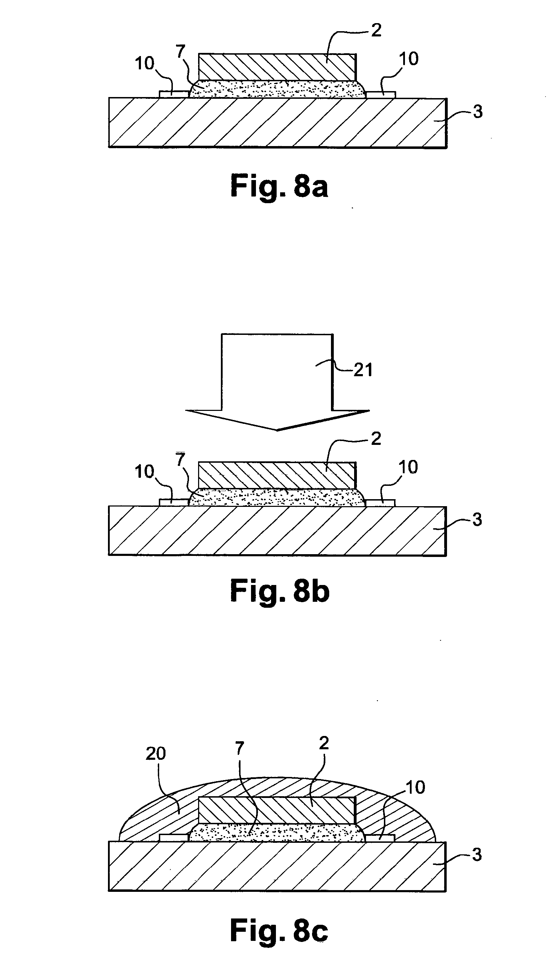

Ainsi, dans un premier temps (figure 8a), le dépôt du revêtement anti-mouillant localisé, et par exemple du SiOₓ₁C_{y1}H_{z1} permet de maitriser par confinement l'étalement de la résine d'enrobage ou underfill 5, 7 sous le composant ou élément hybridé 2, puis dans un second temps, après soumission du composant ainsi obtenu à l'action d'un plasma ou d'un rayonnement ultra-violet 21 (figure 8b), tendant à rendre mouillable ledit revêtement de confinement vis-à-vis d'une résine de recouvrement ou d'enrobage ou « glob-top » 20, et ainsi améliorer ses propriétés d'adhérence avec ladite résine, pour favoriser un enrobage effectif et pérenne du composant après hybridation (figure 8c), et éviter les amorces de rupture, fréquemment observées sur les composant obtenus par hybridation dite « flip chip ».
Cette résine d'enrobage peut être de même nature que la résine d'underfill, et par exemple, époxy, silicones, acrylates....

Le procédé de l'invention offre donc aussi la possibilité de localiser aisément par traitement, en utilisant soit des masques mécaniques soit des masques optiques, des zones de forte énergie de surface. Ce faisant, cela permet de localiser des gouttelettes d'espèces chimiques variées, des liquides peu visqueux (eau, molécules biologiques, huile) à visqueux (colle, résine, peinture) sur un motif déterminé par le masque, et d'autre part, de localiser l'adhérence de cellules vivantes (et l'adsorption de molécules biologiques) dans ces zones.

Selon une variante de l'invention représentée au sein de la figure 4, on modifie la zone de non mouillabilité 10 en définissant une surface supplémentaire 11, en l'espèce opposée à la surface 9, et destinée à recueillir l'éventuel surplus de résine d'enrobage.

On peut avantageusement mettre en oeuvre ce procédé pour des composants particuliers et notamment pour empêcher le dépôt ou la migration de la résine d'enrobage sous la puce 2, et de manière générale sous le composant actif.

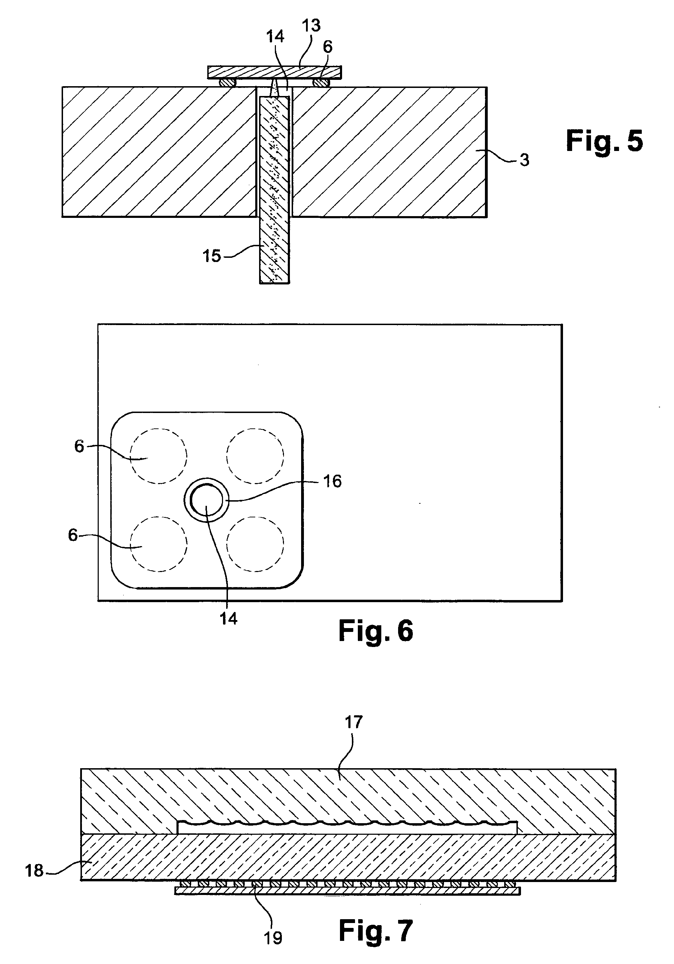

On a ainsi représenté en relation avec les figures 5 et 6, un composant optoélectronique dans lequel on hybride un laser 13 sur un substrat 3. Ce dernier est percé d'un orifice traversant 14, destiné à laisser passer le faisceau laser et à accueillir une fibre optique 15. Bien évidemment, dans le cadre d'un tel VCSEL, la zone de la puce située à l'aplomb de l'orifice 14 doit être impérativement dépourvue de résine d'enrobage. A cette fin, on dépose à la périphérie de l'orifice traversant 15 un anneau 16 d'un matériau de non mouillabilité vis-à-vis de la résine d'enrobage.

On a également représenté, en relation avec la figure 7, un autre composant particulier mettant en oeuvre ce procédé d'enrobage. En l'espèce, on souhaite que la colle assurant la solidarisation de la barrette de lentilles 17 sur un substrat transparent 18 ne vienne pas perturber la fonction optique desdites lentilles 17 et n'affecte pas le chemin optique des faisceaux lasers issus d'une barrette de laser 19, hybridée sur l'autre face dudit substrat transparent 18. Afin d'éviter à la colle de migrer et de s'étaler sur les chemins optiques, on procède au dépôt d'un revêtement anti-mouillant, par exemple sous la forme d'un cordon périphérique à l'instar de l'exemple précédemment décrit.

On conçoit tout l'intérêt du procédé de l'invention, dans la simplification des moyens à mettre en oeuvre pour assurer l'enrobage de la zone d'hybridation de composants pour en garantir la tenue mécanique.

## Revendications

1. Procédé d'enrobage de la zone d'hybridation d'un composant constitué de deux éléments (2, 3) associés l'un à l'autre au moyen d'un matériau de brasure (6), consistant à déposer à proximité dudit composant une substance d'enrobage (5, 7) susceptible de venir combler par capillarité le volume défini entre les éléments hybridés dudit composant, procédé dans lequel on définit à la périphérie de la zone d'hybridation sur l'élément inférieur (3) dudit composant une zone (10) de non mouillabilité vis-à-vis de la dite substance, réalisée par dépôt d'un revêtement anti-mouillant vis à vis de la dite substance, et définissant sur ledit élément inférieur (3), à l'aplomb de l'hybridation, une surface mouillante (12) pour la substance d'enrobage, ***caractérisé* en ce que** le dépôt du revêtement anti-mouillant sur l'élément inférieur (3) est obtenu par PECVD, et **en ce que** la zone de non-mouillabilité (10) vis à vis de la substance d'enrobage (5, 7) définit également une surface (11) contiguë et continue à la surface mouillante (12), destinée à recueillir un excès éventuel de la substance d'enrobage.

2. Procédé d'enrobage selon la revendication 1, ***caractérisé* en ce que** le revêtement anti-mouillant est constitué de SiOC ou de C₄F₈.

3. Procédé d'enrobage selon l'une des revendications 1 et 2, ***caractérisé* en ce que** la zone de non-mouillabilité (10) vis à vis de la substance d'enrobage (5, 7) définit également une surface (9) contiguë et continue à la surface mouillante (12), destinée à recevoir le dépôt de ladite substance d'enrobage.

4. Procédé d'enrobage selon la revendication 3, ***caractérisé* en ce que** la surface de recueil (11) de la substance d'enrobage en excès est située de manière opposée à la surface de dépôt (9) de ladite substance par rapport au composant hybridé.

5. Procédé d'enrobage selon l'une des revendications 1 à 4, ***caractérisé* en ce que** l'on définit également une surface de non mouillabilité (14) vis à vis de la substance d'enrobage sur ledit premier élément (3), située au sein de la zone d'hybridation et au niveau d'une zone particulière dans laquelle on ne souhaite pas la présence de la substance d'enrobage, cette surface de non-mouillabilité étant également obtenue par dépôt d'un revêtement anti-mouillant vis à vis de ladite substance.

6. Procédé d'enrobage selon l'une des revendications 1 à 5, ***caractérisé* en ce que** l'on confère au revêtement anti-mouillant postérieurement à la migration de la substance d'enrobage (5, 7) entre les éléments hybridés, à nouveau des propriétés de mouillabiltié par soumission du composant obtenu à l'action d'un plasma ou à l'action d'un rayonnement ultra-violet.

7. Procédé d'enrobage selon la revendication 6, ***caractérisé* en ce que** postérieurement au traitement du plasma ou des rayons ultra-violets, on enrobe le composant ainsi obtenu d'une résine d'enrobage (20).

8. Procédé d'enrobage selon l'une des revendications 1 à 7, ***caractérisé* en ce que** le revêtement anti-mouillant est constitué de SiOₓ₁C_{y1}H₂,, dans lequel :
• 0,3 ≤ x10 ≤ 0,4
• 0,15 ≤ y1 ≤ 0,2 et
• 0,4 ≤ z1 ≤ 0,55.

## Patentansprüche

1. Verfahren zur Umhüllung der Hybridisierungszone eines Bauteils, das aus zwei Elementen (2, 3) besteht, die mittels eines Lötmaterials (6) miteinander verbunden sind, umfassend, im Nahbereich des Bauteils eine Umhüllungssubstanz (5, 7) abzuscheiden, die durch Kapillarität das zwischen den hybridisierten Elementen des Bauteils gebildete Volumen zu füllen vermag, bei welchem Verfahren am Umfang der Hybridisierungszone am unteren Element (3) des Bauteils eine gegenüber der Substanz nicht benetzbare Zone (10) gebildet wird, die durch Abscheiden eines gegenüber der Substanz benetzungsverhindernden Überzugs hergestellt wird, und Ausbilden am unteren Element (3), in der Lotrechten zur Hybridisierung, einer für die Umhüllungssubstanz benetzenden Fläche (12), **dadurch gekennzeichnet, dass** die Abscheidung des benetzungsverhindernden Überzugs am unteren Element (3) durch PECVD erzielt wird, und dass die gegenüber der Umhüllungssubstanz (5, 7) nicht benetzbare Zone (10) auch eine an die benetzende Fläche (12) angrenzende und durchgehende Fläche (11) bildet, die dazu bestimmt ist, einen eventuellen Überschuss der Umhüllungssubstanz aufzufangen.

2. Umhüllungsverfahren nach Anspruch 1, **dadurch gekennzeichnet, dass** der benetzungsverhindernde Überzug aus SiOC oder C4F8 besteht.

3. Umhüllungsverfahren nach einem der Ansprüche 1 und 2, **dadurch gekennzeichnet, dass** die gegenüber der Umhüllungssubstanz (5, 7) nicht benetzbare Zone (10) auch eine an die benetzende Fläche (12) angrenzende und durchgehende Fläche (9) bildet, die dazu bestimmt ist, die Abscheidung der Umhüllungssubstanz aufzunehmen.

4. Umhüllungsverfahren nach Anspruch 3, **dadurch gekennzeichnet, dass** die Auffangfläche (11) für die überschüssige Umhüllungssubstanz sich der Abscheidungsfläche (9) für die Substanz in Bezug auf das hybridisierte Bauteil entgegengesetzt befindet.

5. Umhüllungsverfahren nach einem der Ansprüche 1 bis 4, **dadurch gekennzeichnet, dass** auch eine gegenüber der Umhüllungssubstanz nicht benetzbare Fläche (14) am ersten Element (3) gebildet wird, die sich in der Hybridisierungszone und im Bereich einer bestimmten Zone befindet, in der das Vorhandensein der Umhüllungssubstanz nicht gewünscht ist, wobei die nicht benetzbare Fläche auch durch Abscheiden eines gegenüber der Substanz benetzungsverhindernden Überzugs erhalten wird.

6. Umhüllungsverfahren nach einem der Ansprüche 1 bis 5, **dadurch gekennzeichnet, dass** dem benetzungsverhindernden Überzug nach der Wanderung der Umhüllungssubstanz (5, 7) zwischen die hybridisierten Elemente wieder Benetzbarkeitseigenschaften verliehen werden, indem das erhaltene Bauteil der Wirkung eines Plasmas oder der Wirkung einer ultravioletten Strahlung ausgesetzt wird.

7. Umhüllungsverfahren nach Anspruch 6, **dadurch gekennzeichnet, dass** nach der Behandlung mit dem Plasma oder den ultravioletten Strahlen das so erhaltene Bauteil mit einem Umhüllungsharz (20) umhüllt wird.

8. Umhüllungsverfahren nach einem der Ansprüche 1 bis 7, **dadurch gekennzeichnet, dass** der benetzungsverhindernde Überzug aus SiOx1Cy1Hz1 besteht, wobei:
• 0,3 ≤ x1 ≤ 0,4
• 0,15 ≤ y1 ≤ 0,2, und
• 0,4 ≤ z1 ≤ 0,55.

## Claims

1. A method of coating the area of hybridization of a component constituted by two elements (2, 3) associated with one another by means of a soldering material (6), comprising depositing in proximity to said component a coating substance (5, 7) capable of filling by capillarity the volume defined between the hybridized elements of said component, method wherein on the periphery of the hybridization area on the lower element (3) of said component is defined an area (10) of non-wettability as regards said substance, the non-wettability area being produced by deposition of a covering that is anti-wetting as regards said substance and defining on said lower element (3), in line with the hybridization, a wetting surface (12) for the coating substance, **characterized in that** the deposition of the anti-wetting covering on the lower element (3) is obtained by PECVD, and **in that** the area of non-wettability (10) as regards the coating substance (5, 7) also defines a surface (11) contiguous and in continuity with the wetting surface (12), intended to collect any excess coating substance.

2. The coating method as claimed in claim 1, **characterized in that** the anti-wetting covering is constituted by SiOC or C₄F₈.

3. The coating method as claimed in one of claims 1 and 2, **characterized in that** the area of non-wettability (10) as regards the coating substance (5, 7) also defines a surface (9) contiguous and in continuity with the wetting surface (12), intended to receive the deposition of said coating substance.

4. The coating method as claimed in claim 3, **characterized in that** the collecting surface (11) of the excess coating substance is located opposite to the deposition surface (9) of said substance relative to the hybridized component.

5. The coating method as claimed in one of claims 1 to 4, **characterized in that** a surface of non-wettability (14) as regards the coating substance is also defined on said first element (3), located in the hybridization area and in a particular area in which the presence of the coating substance is not required, said non-wettability surface also being obtained by deposition of a covering that is anti-wetting as regards said substance.

6. A coating method as claimed in one of claims 1 to 5, **characterized in that** wettability properties are conferred afresh on the anti-wetting covering after the migration of the coating substance (5, 7) between the hybridized elements by subjection of the component obtained to the action of a plasma or to the action of an ultra-violet radiation.

7. The coating method as claimed in claim 6, **characterized in that** after the plasma or ultra-violet radiation treatment, the component so obtained is coated with a coating resin (20).

8. The coating method as claimed in one of claims 1 to 7, **characterized in that** the anti-wetting covering is constituted by SiOₓ₁C_{y1}H_{z1}, wherein:
• 0.3 ≤ x1 ≤ 0.4
• 0.15 ≤ y1 ≤ 0.2 and
• 0.4 ≤ z1 ≤ 0.55.
